# EUROPÄISCHE PATENTSCHRIFT

(11) **EP 0 512 161 B1**
(45) Veröffentlichungstag und Bekanntmachung des Hinweises auf die Patenterteilung: **02.07.1997**
(21) Anmeldenummer: 91121199.3
(22) Anmeldetag: 11.12.1991
(51) Int. Cl.: H03K 17/94

(54) **Schalteinrichtung, insbesondere zur Verwendung in Kraftfahrzeugen**
Switching equipment, particularly for use in motor vehicles
Equipement de commutation, applicable notamment dans les véhicules automobiles

(30) Priorität: 07.05.1991 DE 4114835
(43) Veröffentlichungstag der Anmeldung: 11.11.1992
(73) Patentinhaber: VDO Adolf Schindling AG, D-60487 Frankfurt (DE)
(72) Erfinder: Wallrafen, Werner, W-6231 Sulzbach (DE)
(74) Vertreter: Klein, Thomas, Dipl.-Ing. (FH)

(56) Entgegenhaltungen:
- EP-A- 0 078 511
- DE-C- 3 146 709
- DE-C- 3 828 428

## Beschreibung

Die Erfindung betrifft eine Schalteinrichtung, insbesondere zur Verwendung in Kraftfahrzeugen, gemäß dem Oberbegriff des Patentanspruchs 1.

In Kraftfahrzeugen werden häufig Schalteinrichtungen eingesetzt, bei denen ein Verbraucher in Abhängigkeit von einer auf die Schalteinrichtung einwirkenden physikalischen Größe ein- bzw. ausgeschaltet wird. Die Schalteinrichtungen können beispielsweise als Druck-, Temperatur-, Niveau- oder Abstandsschalter aufgebaut sein und dienen meistens zum Schalten von Warnlampen, Summern oder Relais. Durch Fortschritte auf dem Gebiet der Halbleitertechnik werden die herkömmlich mechanisch aufgebauten Schalteinrichtungen in steigendem Maße durch elektronische Sensoren ersetzt, die ein Schaltsignal abgeben, wenn die physikalische Größe einen vorgegebenen Schwellwert über- bzw. unterschreitet. Durch die Anwendung elektronischer Bauelemente ergeben sich unter anderem fertigungstechnische Vorteile, eine Verringerung der Baugröße, eine Verkürzung der Ansprechzeit und in vielen Fällen sogar ein geringerer Preis.

Ein wesentlicher Nachteil bekannter derartiger elektronischer Zweipunktsensoren besteht jedoch darin, daß drei Anschlüsse benötigt werden - nämlich einer für Masse, einer für die Betriebsspannung und einer als Schaltausgang. Dadurch ergibt sich gegenüber den herkömmlichen mechanisch aufgebauten Zweipunktsensoren ein Mehraufwand bei Steckverbindungen und Leitungen.

Gemäß der DE 38 28 428 C1 ist eine Schalteinrichtung bekannt, bei welcher der Strom durch einen Verbraucher in Abhängigkeit von einer auf die Schalteinrichtung einwirkenden physikalischen Größe schaltbar ist, wobei zwei Anschlüsse der Schalteinrichtung über einen Halbleiterschalter untereinander verbunden werden und ferner den Eingang einer speichernden Stromversorgungsschaltung bilden, wobei ein Sensor ein die physikalische Größe darstellendes elektrisches Signal erzeugt und mit einer Schwellwertschaltung verbunden ist und wobei in Abhängigkeit von dem Ausgangssignal der Schwellwertschaltung der Halbleiterschalter pulsierend gesteuert wird.

Die Erfindung ist durch die Merkmale des Patentanspruchs 1 charakterisiert.

Die erfindungsgemäße Schalteinrichtung kann zusammen mit Warnlampen, Summern oder Relais genauso einfach eingesetzt werden wie die herkömmlichen mechanisch arbeitenden Schalteinrichtungen. Bei vorhandener Masseverbindung durch das Gehäuse und die metallischen Teile des Kraftfahrzeugs ist lediglich eine Leitung zum Vebraucher erforderlich.

Vorzugsweise ist bei der erfindungsgemäßen Schalteinrichtung vorgesehen, daß die speichernde Stromversorgungsschaltung aus einer Gleichrichterdiode und einem Kondensator und aus einer daran anschließenden Stabilisierungsschaltung gebildet ist. Dadurch ist eine kontinuierliche Stromversorgung einzelner in der Schalteinrichtung vorhandener Schaltungen gewährleistet.

Durch die pulsierende Ansteuerung des Verbrauchers ergibt sich ein Vorteil gegenüber den herkömmlichen Schalteinrichtungen dadurch, daß im Fall einer Störung, beispielsweise durch dauerndes Aufleuchten einer Warnlampe, anhand der Pulsation zwischen einem Leitungskurzschluß und einem anderen Defekt mit Hilfe eines geeigneten Diagnosegerätes unterschieden werden kann.

Eine andere Weiterbildung der Erfindung besteht darin, daß das Tastverhältnis im ersten Schaltzustand größer als 0,90 und im zweiten Schaltzustand kleiner als 0,1.

Dieses periodische kurze Einschalten des jeweiligen Verbrauchers im ersten Schaltzustand kann bei einer Fehlerdiagnose dazu verwendet werden, eine Leitungsunterbrechung von dem Schaltzustand "aus" zu unterscheiden.

Um dem Verbraucher im ausgeschalteten Zustand einen möglichst kleinen Strom zuzuführen, wird bei der erfindungsgemäßen Schalteinrichtung ein möglichst geringer Stromverbrauch der vorhandenen Schaltungen angestrebt. Vorzugsweise ist deshalb vorgesehen, daß der Halbleiterschalter ein Feldeffekttransistor ist.

Häufig ist es nützlich, durch eine geeignete Ansteuerung einer akustischen oder optischen Warneinrichtung einen Übergangsbereich zum eigentlichen Grenzwert zu kennzeichnen. Bei der erfindungsgemäßen Schalteinrichtung ist dieses gemäß einer anderen Weiterbildung dadurch möglich, daß die pulsierende Steuerung mit einer oberhalb der Trägheit des Verbrauchers liegenden Frequenz periodisch erfolgt und daß in einem Übergangsbereich vor dem Grenzwert der physikalischen Größe der periodischen Steuerung eine weitere periodische Steuerung mit niedrigerer Frequenz überlagert ist. Dabei kann mit zunehmender Annäherung der physikalischen Größe an den Grenzwert das Tastverhältnis bei der Steuerung mit der niedrigeren Frequenz immer größer werden, so daß der Verbraucher allmählich in einen kontinuierlichen Betrieb übergeht - eine Warnlampe von einem Blinkbetrieb also in ein Dauerlicht übergeht.

Durch die Verwendung von verschiedenen elektronischen Schaltungen in der erfindungsgemäßen Schalteinrichtung sind vielfältige Erweiterungen und Ausbilddungen der erfindungsgemäßen Schalteinrichtung möglich. So kann beispielsweise vorgesehen werden, daß nach dem Anlegen von Spannung an die Anschlüsse unabhängig von der zu messenden physikalischen Größe der Halbleiterschalter vorübergehend in den leitenden Zustand geschaltet wird, so daß eine Kontrolle der angeschlossenen Verbraucher, insbesondere der Lampen, möglich wird.

Die Erfindung läßt zahlreiche Ausführungsformen zu. Eine davon ist schematisch in der Zeichnung anhand mehrerer Figuren dargestellt und nachfolgend beschrieben. Es zeigt:
- Fig. 1: eine Schaltung, die das Verständnis der Erfindung erleichtert;
- Fig. 2: ein Zeitdiagramm der Spannung an den Anschlüssen der Schaltung gemäß Fig. 1;
- Fig. 3: ein Ausführungsbeispiel und
- Fig. 4: ein Zeitdiagramm der Spannung an den Anschlüssen des Ausführungsbeispiels.
Gleiche Teile sind in den Figuren mit gleichen Bezugszeichen versehen.

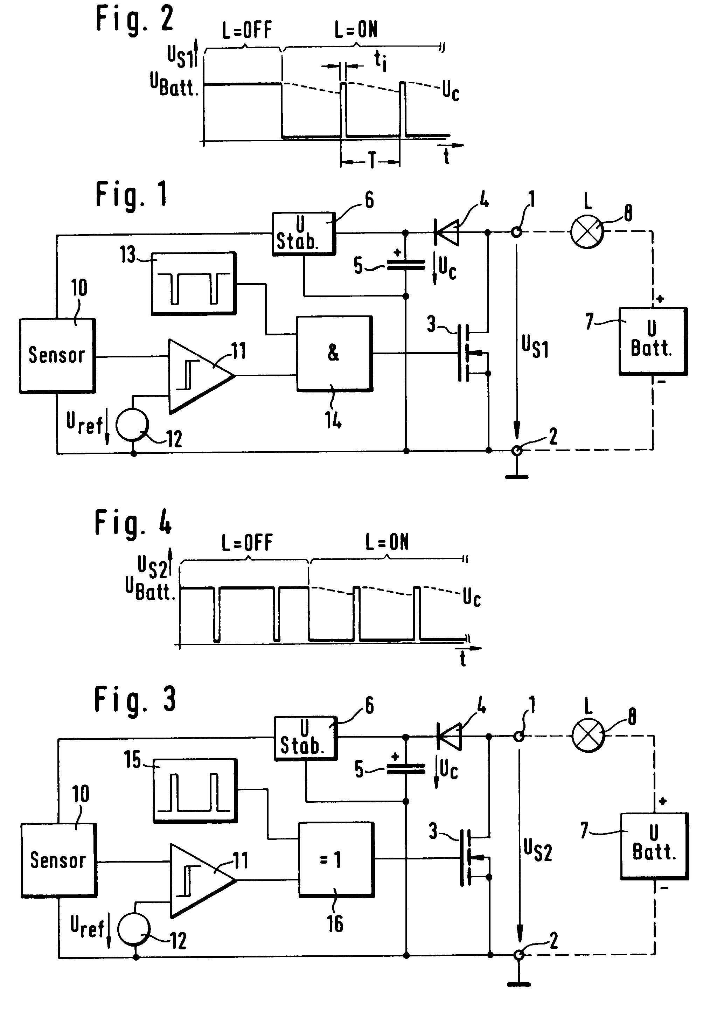

Bei beiden Schaltungen liegt zwischen den Anschlüssen 1, 2 ein Feldeffekttransistor 3. Ferner ist der Anschluß 1 über eine Gleichrichterdiode 4 mit einem Kondensator 5 verbunden, der andererseits an dem Anschluß 2 angeschlossen ist. Die Spannung am Kondensator 5 wird einer an sich bekannten Stabilisierungsschaltung 6 zugeführt, deren Ausgangsspannung zur Versorgung der weiteren Baugruppen der Schalteinrichtung dient. Die erfindungsgemäße Schalteinrichtung wird mit ihren Anschlüssen 1, 2 in einen Stromkreis eingefügt, der in den Figuren 1 und 3 gestrichelt dargestellt ist und beispielsweise aus einer Fahrzeugbatterie 7 und einer Kontrollampe 8 besteht.

Zur Erfassung des Druckes, des Füllstandes, der Temperatur oder anderer physikalischer Größen ist ein Sensor 10 vorgesehen, der mit der stabilisierten Spannung versorgt wird und eine von der jeweiligen Größe abhängige Ausgangsspannung erzeugt. Diese wird in einem Komparator 11 mit einer Bezugsspannung U_{ref} verglichen, die in einer geeigneten Quelle 12 erzeugt wird. Ein Impulsgenerator 13 erzeugt Impulse mit einer Frequenz von etwa 100 Hz und einem Tastverhältnis von etwa 0,95.

Bei der Schaltung nach Fig. 1 werden die von dem Impulsgenerator 13 erzeugten Impulse und das Ausgangssignal des Komparators 11 einer Und-Schaltung 14 zugeführt. Ist die Ausgangsspannung des Sensors 10 kleiner als die Bezugsspannung U_{ref}, so nimmt das Ausgangssignal des Komparators 11 einen niedrigen Pegel an, wodurch am Ausgang der Und-Schaltung 14 eine Spannung abgegeben wird, welche den Halbleiterschalter 3 im nichtleitenden Zustand beläßt. Die Schalteinrichtung befindet sich somit im Aus-Zustand. Die Lampe 8 leuchtet nicht auf. Der zur Versorgung der Schaltungen 10 bis 14 benötigte Strom ist wesentlich geringer als der zum Leuchten der Lampe 8 benötigte Strom. Die in diesem Schaltzustand am Feldeffekttransistor 3 anliegende Spannung ist in Fig. 2 in dem mit L = AUS bezeichneten Zeitraum dargestellt.

Wird die Ausgangsspannung des Sensors 10 größer als die Bezugsspannung U_{ref}, nimmt das Ausgangssignal des Komparators 11 einen höheren Pegel ein, was zur Weiterleitung der vom Impulsgenerator 13 erzeugten Impulse an die Steuerelektrode des Feldeffekttransistors 3 führt. Dieser wird somit periodisch in den leitenden Zustand gesteuert, was in Fig. 2 im mit L = EIN bezeichneten Zeitraum dargestellt ist. Die kurzen Unterbrechungen des leitenden Zustandes dienen dazu, daß über die dann zwischen den Anschlüssen 1 und 2 anliegende Batteriespannung der Kondensator 5 wieder aufgeladen werden kann, wodurch eine Stromversorgung der Schaltungen 10 bis 14 aufrechterhalten wird. Die Unterbrechungen sind jedoch so kurz, daß keine störende Helligkeitseinbuße beim Aufleuchten der Lampe 8 entsteht. Die Spannung U_{c} am Kondensator 5 sinkt zwar zwischen zwei Unterbrechungen etwas ab; bei einer Batteriespannung von 12V und einer Betriebsspannung der Schaltungen 10 bis 14 von beispielsweise 5V ist jedoch eine ungestörte Versorgung möglich.

Bei dem Ausführungsbeispiel nach Fig. 3 ist ein Impulsgenerator 15 vorgesehen, der gegenüber dem Impulsgenerator 13 (Fig. 1) invertierte Impulse erzeugt. Diese werden zusammen mit dem Ausgangssignal des Komparators 11 einer Exklusiv-Oder-Schaltung 16 zugeführt, deren Ausgang mit der Steuerelektrode des Feldeffekttransistors 3 verbunden ist. Durch diese Verknüpfung ändert sich an der Wirkungsweise im Fall des Ein-Zustandes nichts.

Wie in Fig. 4 dargestellt, wird jedoch im Aus-Zustand der Feldeffekttransistor 3 periodisch in den leitenden Zustand geschaltet. Dieses erfolgt jedoch für derart kurze Schaltabschnitte, daß der Strom durch die Lampe 8 nicht die zum Leuchten bzw. Glimmen erforderliche Größe erreicht. Durch die Impulse während des Aus-Zustandes ist es jedoch möglich, mit Hilfe eines geeigneten Diagnosegerätes bei einer Überprüfung festzustellen, ob die Schalteinrichtung infolge einer Leitungsunterbrechung oder beispielsweise im Bereich des Sensors 10 defekt ist. Bei Ausbleiben der Impulse liegt wahrscheinlich eine Leitungsunterbrechung vor, während bei Vorhandensein der Impulse während des Aus-Zustandes zumindest die Leitung zum Sensor in Ordnung ist.

Anstelle der dargestellten Warnlampe 8 sind andere Verbraucher, wie z. B. Summer oder Relais zur Weiterverarbeitung, im Lastkreis mit gleicher Schaltungsanordnung (Fig. 1 und Fig. 3) zuschaltbar.

## Patentansprüche

1. Schalteinrichtung, insbesondere zur Verwendung in Kraftfahrzeugen, mit der der Strom durch einen Verbraucher in Abhängigkeit von einer auf die Schalteinrichtung einwirkenden physikalischen Größe zwischen einem ersten Zustand und einem zweiten Zustand schaltbar ist, wobei zwei Anschlüsse (1, 2) der Schalteinrichtung über einen Halbleiterschalter (3) untereinander verbindbar sind und ferner den Eingang einer speichernden Stromversorgungsschaltung (4, 5, 6) bilden, wobei ein Sensor (10) an seinem Ausgang ein die physikalische Größe darstellendes elektrisches Signal erzeugt, wobei der Ausgang des Sensors (10) mit einem Eingang einer Schwellwertschaltung (11) verbunden ist, und wobei im zweiten Zustand zur Stromversorgung der Schalteinrichtung in Abhängigkeit von dem Ausgangssignal der Schwellwertschaltung (11) der Halbleiterschalter pulsierend gesteuert wird, dadurch gekennzeichnet, daß der Ausgang der Schwellwertschaltung (11) und ein Ausgang eines Impulsgenerators (15) über eine Exklusiv-Oder-Schaltung (16) mit der Steuerelektrode des Halbleiterschalters (3) verbunden sind, wobei das Tastverhältnis der vom Impulsgenerator (15) generierten Impulse so festgelegt ist, daß der Halbleiterschalter (3) in dem ersten Zustand mit einem für Diagnosezwecke geeigneten großen Tastverhältnis pulsierend nichtleitend und in dem zweiten Zustand mit einem zur Stromversorgung der Schalteinrichtung wirksamen kleinen Tastverhältnis pulsierend nichtleitend ist.

2. Schalteinrichtung nach Anspruch 1, dadurch gekennzeichnet, daß die speichernde Stromversorgungsschaltung aus einer Gleichrichterdiode (4) und einem Kondensator (5) und aus einer daran anschließenden Stabilisierungsschaltung (6) gebildet ist.

3. Schalteinrichtung nach Anspruch 1, dadurch gekennzeichnet, daß das Tastverhältnis im ersten Schaltzustand größer als 0,90 ist, und im zweiten Schaltzustand kleiner als 0,10 ist.

4. Schalteinrichtung nach einem der vorhergehenden Ansprüche, dadurch gekennzeichnet, daß der Halbleiterschalter ein Feldeffekttransistor (3) ist.

5. Schalteinrichtung nach einem der vorhergehenden Ansprüche, dadurch gekennzeichnet, daß die pulsierende Steuerung des Halbleiterschalters mit einer oberhalb der Trägheit des Verbrauchers (8) liegenden Frequenz periodisch erfolgt und daß in einem Übergangsbereich vor einem Grenzwert der physikalischen Größe der periodischen Steuerung eine weitere periodische Steuerung mit niedrigerer Frequenz überlagert ist.

6. Schalteinrichtung nach einem der vorhergehenden Ansprüche, dadurch gekennzeichnet, daß nach dem Anlegen von Spannung an die Anschlüsse (1, 2) unabhängig von der zu messenden physikalischen Größe der Halbleiterschalter (3) vorübergehend in den leitenden Zustand geschaltet wird, so daß eine Kontrolle der angeschlossenen Verbraucher (8) möglich wird.

7. Verwendung der Schalteinrichtung nach einem der vorhergehenden Ansprüche, dadurch gekennzeichnet, daß die pulsierende Steuerung des Halbleiterschalters für eine Fehlerdiagnose genutzt wird.

## Claims

1. A switching device, particularly for use in motor vehicles, with which the current through a consumer can be switched between a first state and a second state depending on a physical quantity acting on the switching device, wherein two connections (1, 2) of the switching device can be connected to each other via a semiconductor switch (3) and in addition form the input of a retransmitting current supply circuit (4, 5, 6), wherein a sensor (10) generates, at its output, an electrical signal representing the physical quantity, wherein the output of the sensor (10) is connected to an input of a threshold value circuit (11), and wherein in the second state the semiconductor switch is controlled in a pulsed manner, depending on the output signal from the threshold value circuit (11), for the supply of current to the switching device, characterised in that the output of the threshold value circuit (11) and an output of a pulse generator (15) are connected to the control electrode of the semiconductor switch (3) via an exclusive OR-gate (16), wherein the pulse-width repetition rate of the pulses generated by the pulse generator (15) is fixed so that the semiconductor switch (3) is non-conducting in the first state, pulsating at a high pulse width repetition rate which is suitable for diagnostic purposes, and it is non-conducting in the second state, pulsating at a low pulse-width repetition rate which is effective for supplying current to the switching device.

2. A switching device according to claim 1, characterised in that the retransmitting current supply circuit is formed from a rectifier diode (4) and a capacitor (5), and from a stabilisation circuit (6) connected thereto.

3. A switching device according to claim 1, characterised in that the pulse-width repetition rate in the first switching state is greater than 0.90, and is less than 0.10 in the second switching state.

4. A switching device according to any one of the preceding claims, characterised in that the semiconductor switch is a field-effect transistor (3).

5. A switching device according to any one of the preceding claims, characterised in that the pulsating control of the semiconductor is effected periodically at a frequency which is higher than the inertia of the consumer (8), and that a further periodic control having a lower frequency is superimposed in a transition region before a limiting value of the physical quantity of the periodic control.

6. A switching device according to any one of the preceding claims, characterised in that after the application of voltage to the connections (1, 2) the semiconductor switch (3) is momentarily switched to its conducting state irrespective of the physical quantity to be measured, so that it is possible to check the connected consumer (8).

7. A use of the switching device according to any one of the preceding claims, characterised in that the pulsating control of the semiconductor switch is utilised for fault diagnosis.

## Revendications

1. Dispositif de commutation, destiné à être utilisé notamment dans des véhicules automobiles, au moyen duquel le courant traversant un appareil utilisateur peut être commuté entre un premier état et un deuxième état, en fonction d'une grandeur physique agissant sur le dispositif de commutation, deux bornes (1, 2) du dispositif de commutation pouvant être connectées entre elles par l'intermédiaire d'un interrupteur (3) à semi-conducteur et formant en outre l'entrée d'un circuit (4, 5, 6) d'alimentation en courant avec accumulation, un capteur (10) produisant à sa sortie un signal électrique représentant une grandeur physique, la sortie du capteur (10) étant connectée à l'entrée d'un circuit (11) de valeur de seuil et l'interrupteur à semi-conducteur étant commandé par impulsions dans le second état, en fonction du signal de sortie du circuit (11) de valeur de seuil, en vue de l'alimentation en courant du dispositif de commutation, caractérisé en ce que la sortie du circuit (11) de valeur de seuil et une sortie d'un générateur (15) d'impulsions étant connectées par l'intermédiaire d'un circuit OU exclusif (16) à l'électrode de commande de l'interrupteur (3) à semi-conducteur, le rapport entre les impulsions générées par le générateur d'impulsions (15) étant fixé de façon telle que l'interrupteur (3) à semi-conducteur est, dans le premier état, non conducteur par impulsion avec un rapport entre impulsions élevé et approprié à des buts de diagnostic et est dans le second état non conducteur par impulsions avec un faible rapport entre impulsions, efficace pour l'alimentation en courant du dispositif de commutation.

2. Dispositif de commutation selon la revendication 1, caractérisé en ce que le circuit d'alimentation en courant avec accumulation est constitué d'une diode redresseuse (4) et d'un condensateur (5) ainsi que d'un circuit de stabilisation (6) qui s'y rattache.

3. Dispositif de commutation selon la revendication 1, caractérisé en ce que le rapport entre les impulsions, dans le premier état de commutation,est supérieur à 0,90, et, dans le second état de commutation, inférieur à 0,10.

4. Dispositif selon l'une des revendications précédentes, caractérisé en ce que l'interrupteur à semi-conducteur est un transistor (3) à effet de champ.

5. Dispositif de commutation selon l'une des revendications précédentes, caractérisé en ce que la commande par impulsions de l'interrupteur à semi-conducteur s'effectue périodiquement, avec une fréquence qui se situe au-dessus de l'inertie de l'appareil utilisateur et que, dans une zone de transition précédant une valeur de seuil de la grandeur physique de la commande périodique, une autre commande périodique de fréquence inférieure est superposée à la commande périodique.

6. Dispositif de commutation selon l'une des revendications précédentes, caractérisé en ce qu'après l'application de la tension aux bornes (1, 2), l'interrupteur (3) à semi-conducteur est commuté passagèrement à l'état conducteur indépendamment de la grandeur physique qui doit être mesurée, si bien qu'un contrôle des appareils utilisateurs (8) connectés est possible.

7. Utilisation du dispositif de commutation selon l'une des revendications précédentes, caractérisée en ce que la commande par impulsions de l'interrupteur à semi-conducteur est utilisée pour un diagnostic d'erreur ou de panne.
